# FASCICULE DE BREVET EUROPEEN

(11) **EP 1 401 252 B1**
(45) Date de publication et mention de la délivrance du brevet: **16.04.2008**
(21) Numéro de dépôt: 03292275.9
(22) Date de dépôt: 16.09.2003
(51) Int. Cl.: H05K 7/20

(54) **Armoire climatisée pour équipements, notamment de téléphonie**
Gekühlter Elektronikschrank, insbesondere für Fernsprechanlagen
Cooled electrical cabinet, especially for telephone systems

(30) Priorité: 19.09.2002 FR 0211600
(43) Date de publication de la demande: 24.03.2004
(73) Titulaire: Alcatel Lucent, 75008 Paris (FR)
(72) Inventeur: Le Gall, Charles, Le Rhu Servel 22300 Lannion (FR)
(74) Mandataire: Sciaux, Edmond

(56) Documents cités:
- WO-A-99/08354
- DE-A- 2 844 672
- DE-A- 3 030 136
- US-A- 6 082 441

## Description

L'invention concerne le domaine des conteneurs climatisés, destinés à recevoir des équipements.

Dans de nombreux domaines, tels que la téléphonie, des équipements doivent être installés dans des zones soumises aux variations climatiques. Généralement, ces équipements sont installés dans un conteneur fermé, également appelé armoire, afin de ne pas être directement exposés aux intempéries et/ou aux actes de malveillance.

Certains de ces équipements étant constitués de composants, comme par exemple les batteries ou les dispositifs optiques, qui ne supportent pas les fortes variations de températures, il est donc nécessaire de climatiser les conteneurs dans lesquels ils sont installés.

Ainsi, il a été envisagé d'équiper les conteneurs d'un échangeur de chaleur de type air/air. Il a également été proposé d'équiper le conteneur de parois de type « double peau ». Mais les performances de ces dispositifs se sont vite révélées insuffisantes.

On a alors conçu des conteneurs comportant une paroi interne délimitant un volume pour recevoir un équipement et une paroi externe séparant le conteneur de son environnement, une troisième paroi centrale étant disposée entre les parois interne et externe. La paroi centrale et la paroi interne définissent un compartiment interne dans lequel circule l'air provenant du volume interne d'une part, et d'autre part de l'air provenant de l'extérieur circule dans le compartiment externe défini par la paroi centrale et la paroi externe. La paroi centrale joue ainsi le rôle d'un échangeur de calories entre les flux d'air circulant respectivement dans les compartiments externe et interne.

De tels conteneurs sont par exemple, connus de DE-A-3030136, DE-A-2844672 et WO-A-9908354.

US-A-6082441 propose de plus de revêtir la paroi extérieure d'éléments créant de l'ombre ou de la doubler avec une paroi ayant un coefficient de réflexion réduit de telle manière à ce que l'air intérieur serve de couche thermiquement isolante.

Mais, cette solution n'est plus suffisamment efficace lorsque l'élévation de température devient supérieure à environ 20°C, et se montre quasiment inutile lorsque la température extérieure devient supérieure à environ 40°C. Lorsque le conteneur est directement exposé au rayonnement solaire, la paroi externe esr alors portée à une température très élevée. L'air extérieur circulant dans le compartiment externe se trouve alors surchauffé à son contact et ne peut plus absorber les calories de l'air circulant dans le compartiment interne. Par ailleurs, cette solution n'assure pas une isolation suffisante lorsque les températures externes sont très basses. En effet l'air du compartiment externe absorbe alors les calories de l'air du compartiment interne par l'intermédiaire de la paroi centrale. Au travers de la paroi interne, l'air du compartiment interne abaisse alors excessivement la température de l'air environnant l'équipement ce qui perturbe son fonctionnement.

Il a également été proposé d'installer un dispositif d'air conditionné à l'intérieur des conteneurs, mais, d'une première part, la fiabilité de ces dispositifs n'est pas garantie, d'une deuxième part, ils nécessitent des interventions de maintenance assez fréquentes, et d'une troisième part, ils augmentent très sensiblement le coût des conteneurs.

Par conséquent, aucune solution connue n'apporte une entière satisfaction.

L'invention a donc pour but de remédier à tout ou partie des inconvénients précités en proposant un conteneur susceptible de permettre une maîtrise efficace de la température environnant l'équipement qu'il contient, même à des températures extrêmes, notamment à basse température jusqu'à -30°C ou à haute température jusqu'à +50°C. Elle propose à cet effet un conteneur comprenant des parois délimitant une zone interne, pouvant loger au moins un équipement, et dont l'une au moins est constituée d'au moins trois sous-parois espacées les unes des autres de manière à définir au moins un premier espace de circulation d'air communiquant avec l'extérieur du conteneur par au moins deux ouvertures externes et un second espace de circulation d'air communiquant avec la zone interne par au moins deux ouvertures internes, la première sous-paroi étant constituée d'un matériau isolant thermiquement.

Par définition, on appelle première sous-paroi (ou sous-paroi externe) celle qui est en regard de l'extérieur du conteneur, deuxième sous-paroi (ou sous-paroi interne) celle qui est en regard de la zone interne et troisième sous-paroi (ou sous-paroi centrale) celle qui est intercalée entre les première et deuxième sous-parois.

La première sous-paroi est constituée d'un matériau isolant thermiquement.

De préférence, la troisième sous-paroi est constituée d'un matériau destiné à assurer un transfert de calories efficace entre les premier et second espaces.

De la sorte, on crée au moins un flux d'air interne et un flux d'air externe qui peuvent échanger des calories par l'intermédiaire de la sous-paroi centrale.

La structure du conteneur (ou armoire) sert alors non seulement à protéger les équipements, mais également d'échangeur de chaleur.

De préférence en outre la seconde sous-paroi est également constituée d'un matériau isolant thermiquement. Ainsi l'isolation thermique est encore renforcée et la maîtrise de la température gagne en efficacité.

Pour assurer une efficacité optimale de l'invention, il est souhaitable qu'il n'y ai pas de continuité thermique entre les première, seconde et troisième sous-parois.

Par ailleurs, le conteneur peut être équipé d'au moins un premier dispositif de circulation d'air permettant d'aspirer de l'air à l'extérieur du conteneur, par au moins une première ouverture externe, puis de le faire circuler dans le premier espace avant de l'expulser vers l'extérieur par au moins une seconde ouverture externe. Une partie au moins de ce premier dispositif de circulation d'air est préférentiellement installée sensiblement au niveau de la seconde ouverture externe.

A la place, ou en complément, du premier dispositif de circulation d'air, on peut également prévoir au moins un second dispositif de circulation d'air permettant d'aspirer de l'air dans la zone interne, par au moins une première ouverture interne, puis de le faire circuler dans le second espace avant de l'expulser dans la zone interne par au moins une seconde ouverture interne. Une partie au moins de ce second dispositif de circulation d'air est préférentiellement installée sensiblement au niveau de la seconde ouverture interne.

Qu'il s'agisse du premier ou du second dispositif de circulation d'air, il est avantageux qu'il comporte au moins un ventilateur.

En outre, le conteneur peut comporter un dispositif de commande permettant de contrôler le fonctionnement du premier et/ou du second dispositif(s) de circulation d'air. Ce dispositif de commande peut même être agencé sous la forme d'un thermostat de manière à réguler la température dans la zone interne.

Dans un mode de réalisation avantageux, le conteneur comporte au moins trois parois constituées des sous-parois. Dans ce cas, il est préférable que les trois parois communiquent entre-elles de manière à constituer un unique élément conformé. Ces trois parois sont par exemple deux parois latérales et une paroi supérieure formant le toit du conteneur.

Enfin, la direction de circulation de l'air dans le premier espace est préférentiellement opposée à celle de l'air dans le second espace.

Le conteneur selon l'invention trouve une application particulièrement intéressante lorsque les équipements à loger sont des équipements de téléphonie.

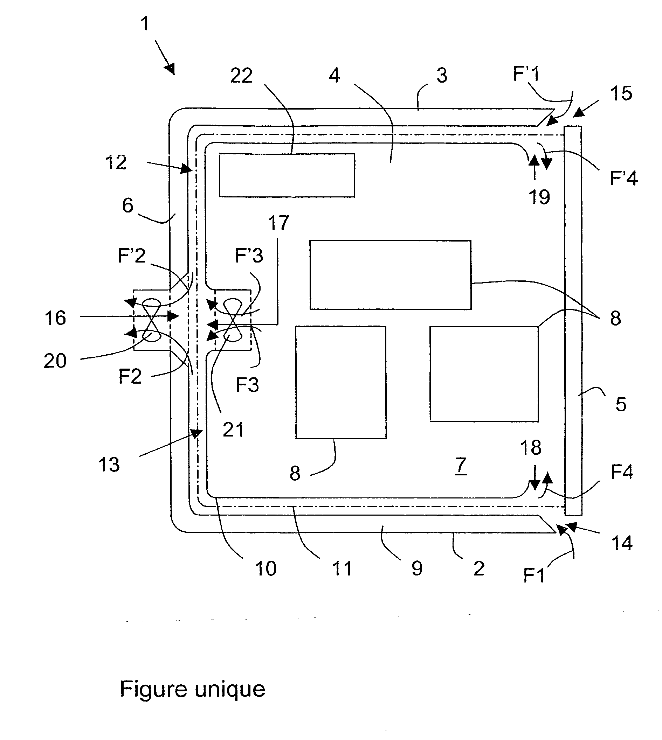

D'autres caractéristiques et avantages de l'invention apparaîront à l'examen de la description détaillée ci-après, et de l'unique figure annexée qui illustre de façon schématique, dans une vue en coupe verticale, un exemple de réalisation d'une partie d'un conteneur climatisé selon l'invention. Cette figure pourra non seulement servir à compléter l'invention, mais aussi contribuer à sa définition, le cas échéant.

Le conteneur (ou armoire) 1 illustré comporte deux parois latérales (ici verticales) 2 et 3, une paroi avant 4 (ici également verticale), une paroi inférieure 5, constituant un plancher de support, une paroi supérieure 6, constituant un toit, et une paroi arrière (non représentée), également verticale et placée sensiblement en regard de la paroi avant 4. Les première 2 et seconde 3 parois latérales sont placées sensiblement l'une en regard de l'autre, tandis que la paroi supérieure 6 est placée sensiblement en regard de la paroi inférieure 5. Une fois assemblées, ces parois délimitent une zone interne fermée 7 dans laquelle sont logés plusieurs équipements 8 (ici trois). Ces équipements 8 sont par exemple des composants optiques de téléphonie et une batterie. Généralement, la paroi avant 4 est constituée par une ou deux portes permettant l'accès à la zone interne 7.

Dans l'exemple illustré, au moins la paroi supérieure 6 et les première 2 et seconde 3 parois latérales constituent un unique élément plié de manière à délimiter trois faces de l'armoire 1. Bien entendu, les parois avant 4 et/ou arrière pourraient également constituer ledit élément plié. Cet unique élément, et par conséquent les trois parois 2, 3 et 6, sont ici constituées de trois sous-parois 9, 10 et 11.

La première sous-paroi 9 est au contact de l'air extérieur. La deuxième sous-paroi 10 est en regard de la zone interne 7, au contact de l'air intérieur. La troisième sous-paroi 11 est intercalée entre les première 9 et deuxième 10 sous-parois. Ces trois sous-parois 9-11 sont espacées l'une de l'autre de manière à définir deux espaces de circulation d'air 12 et 13. Plus précisément, les première 9 et troisième 11 sous-parois définissent un premier espace 12, dit espace extérieur, tandis que les deuxième 10 et troisième 11 sous-parois définissent un second espace 13, dit espace intérieur.

L'espace extérieur 12 communique avec l'extérieur par au moins deux ouvertures externes. Dans l'exemple illustré, on prévoit trois ouvertures externes 14, 15 et 16. La première ouverture externe 14 est formée à l'extrémité de la première paroi latérale 2, située à proximité de la paroi inférieure 5, la deuxième ouverture externe 15 est formée à l'extrémité de la seconde paroi latérale 3, située à proximité de la paroi inférieure 5, tandis que la troisième ouverture externe 16 est formée dans la première sous-paroi 9 de la paroi supérieure 6.

L'espace intérieur 13 communique avec la zone interne 7 (c'est-à-dire l'intérieur de l'armoire 1) par au moins deux ouvertures internes. Dans l'exemple illustré, on prévoit trois ouvertures internes 17, 18 et 19. La première ouverture interne 17 est formée dans la deuxième sous-paroi 10 de la paroi supérieure 6, la deuxième ouverture interne 18 est formée à l'extrémité de la première paroi latérale 2, située à proximité de la paroi inférieure 5, et la troisième ouverture interne 19 est formée à l'extrémité de la seconde paroi latérale 3, située à proximité de la paroi inférieure 5.

Préférentiellement, l'armoire 1 comporte au moins un premier dispositif de circulation d'air 20 permettant d'aspirer de l'air extérieur par les première 14 et deuxième 15 ouvertures externes (d'entrée), puis de le faire circuler dans l'espace extérieur 12 avant de l'expulser à l'extérieur par la troisième ouverture externe 16 (de sortie). L'aspiration de l'air extérieur est préférable dans la mesure où elle permet d'éviter une surchauffe au niveau des entrées d'air.

Dans l'exemple illustré, le premier dispositif de circulation d'air 20 est préférentiellement installé sur la sous-paroi 9 de la paroi supérieure 6 au niveau de la troisième ouverture externe 16. Il s'agit ici d'un ventilateur aspirant l'air extérieur de sorte qu'il circule, dans l'espace extérieur 12 (entre les première 9 et troisième 11 sous-parois) entre les première 14 et troisième 16 ouvertures externes en suivant les flèches F1 et F2 et entre les deuxième 15 et troisième 16 ouvertures externes en suivant les flèches F'1 et F'2.

Egalement de préférence, l'armoire 1 comporte au moins un second dispositif de circulation d'air 21 permettant d'aspirer de l'air intérieur par la première ouverture interne 17 (d'entrée), puis de le faire circuler dans l'espace intérieur 13 avant de l'expulser dans la zone interne 7 par les deuxième 18 et troisième 19 ouvertures internes (de sortie).

Dans l'exemple illustré, le second dispositif de circulation d'air 21 est préférentiellement installé sur la sous-paroi 10 de la paroi supérieure 6 au niveau de la première ouverture interne 17. Il s'agit ici d'un ventilateur aspirant l'air intérieur de sorte qu'il circule, dans l'espace intérieur 13 (entre les deuxième 10 et troisième 11 sous-parois) entre la première ouverture interne 17 et les deuxième 18 et troisième 19 ouvertures internes en suivant les flèches F3 et F4 et F'3 et F'4.

Les ventilateurs 20 et 21 sont par exemple alimentés par une batterie de 48V (volts), implantée dans la zone interne 7 et de nature à permettre une vitesse de circulation de l'air dans les espaces extérieur 12 et intérieur 13 au moins égale à environ 1,5 m/s (par exemple).

Bien entendu, à la place de ventilateurs, on pourrait utiliser un autre type de dispositif de circulation d'air, comme par exemple une turbine.

Par ailleurs, on pourrait n'utiliser qu'un unique dispositif de circulation d'air installé sur le circuit de circulation d'air intérieur ou extérieur. Mais, le mode de réalisation proposé est actuellement préféré, dans la mesure où il permet de faire circuler l'air intérieur et l'air extérieur dans des directions opposées, ce qui augmente le transfert thermique entre les deux flux d'air intérieur et extérieur.

En outre, l'armoire (ou conteneur) 1 peut comporter, comme illustré, un dispositif de commande 22 chargé de contrôler le fonctionnement du premier 20 et/ou du second 21 dispositif(s) de circulation d'air. Plusieurs modes de réalisation peuvent être envisagés pour ce dispositif de commande. Il peut en effet être programmé de manière à déclencher le fonctionnement d'un ou plusieurs dispositifs de circulation d'air pendant certaines périodes de la journée, ou être couplé à un capteur de température (interne ou externe) de manière à réguler (tel un thermostat) la température dans la zone interne 7 par une gestion du fonctionnement de l'un au moins des dispositifs de circulation d'air.

On peut ainsi privilégier le fonctionnement en convection forcée lors des fortes températures et le fonctionnement en convection naturelle (ou non forcée) lors des basses températures (la couche d'air interne constituant alors une couche d'isolation supplémentaire). De plus, cela permet de limiter les temps de fonctionnement des dispositifs de circulation d'air, et par conséquent d'en prolonger la durée de vie tout en espaçant les opérations de maintenance. En outre, cela permet de désactiver les dispositifs de circulation d'air lorsque la température extérieure devient inférieure à un seuil.

La première sous-paroi 9 est constituée d'un matériau isolant thermiquement, de manière à limiter les effets du soleil pendant les fortes températures et les effets du froid pendant les basses températures. Par exemple, on pourra choisir un matériau présentant un coefficient de conductibilité thermique K inférieur à environ 1,5 W/m²/°C. A titre d'exemple, on pourra choisir un matériau de type mousse polyuréthane d'environ 20 mm d'épaisseur.

Il est avantageux de choisir pour la troisième sous-paroi 11 (ou sous-paroi centrale) un matériau permettant de maximiser l'échange de calories entre les flux d'air intérieur et extérieur. Par exemple, on pourra choisir un matériau présentant un coefficient de conductibilité thermique K en convection naturelle (non forcée) de l'ordre de 7 W/m²/°C, de manière à atteindre une valeur d'au moins 15 W/m²/°C en convection forcée (c'est-à-dire lorsque les dispositifs de circulation d'air fonctionnent). A titre d'exemple, on pourra choisir une tôle en aluminium d'environ 0,5 mm d'épaisseur. Cette tôle peut également être conformé, par exemple en U, de manière à augmenter la surface d'échange offerte par la sous-paroi 11.

Afin de renforcer la surface d'échange offerte par les sous-parois 9-11, on peut utiliser des plaques ondulées, par exemple avec un pas de 20 mm.

Grâce à l'invention, il est désormais possible de contrôler les variations de température à l'intérieur de l'armoire, par exemple à quelques degrés près.

Par ailleurs, il est désormais possible d'utiliser l'armoire, de façon efficace, dans des conditions de température comprises entre environ -30°C et +50°C.

L'invention ne se limite pas aux modes de réalisation de conteneur décrits ci-avant, seulement à titre d'exemple, mais elle englobe toutes les variantes que pourra envisager l'homme de l'art dans le cadre des revendications ci-après.

Ainsi, on a décrit une double circulation d'air dans deux parois latérales et la paroi supérieure (ou toit). Mais, cette double circulation d'air pourrait n'être assurée que dans le toit et/ou dans une ou plusieurs parois latérales, y compris la paroi arrière, voire même dans la paroi inférieure et/ou la paroi avant.

Par ailleurs, on a décrit des espaces de circulation d'air (intérieur et extérieur) présentant deux ouvertures d'entrée et une ouverture de sortie ou une ouverture d'entrée et deux ouvertures de sortie. Mais, l'invention s'applique également aux espaces présentant une seule ouverture d'entrée et une seule ouverture de sortie, ou plusieurs ouvertures d'entrée et plusieurs ouvertures de sortie, équipées ou non, pour certaines, d'un dispositif de circulation d'air.

En outre, on a décrit des espaces de circulation d'air intérieur et extérieur présentant respectivement une ouverture d'entrée interne et une ouverture de sortie externe dans la paroi avant. Mais ces ouvertures pourraient être placées en toute autre position dès lors qu'elles permettent la circulation d'air à l'intérieur des espaces intérieur et extérieur. Il en va de même pour les positions des ouvertures de sortie internes et des ouvertures d'entrée externes.

De plus, on a décrit une armoire dans laquelle les dispositifs de circulation d'air étaient placés au niveau de la paroi supérieure (ou toit), mais ces dispositifs pourraient être placés sur toute autre paroi constituée de trois sous-parois.

## Revendications

1. Conteneur (1) comprenant des parois (2-6) délimitant une zone interne (7) propre à loger au moins un équipement (8), l'une au moins desdites parois (2-6) étant constituée d'au moins trois sous-parois (9-11) espacées les unes des autres de manière à définir au moins un premier (12) et un second (13) espaces de circulation d'air, ledit premier espace (12) communiquant avec l'extérieur dudit conteneur par au moins deux ouvertures externes (14-16), et ledit second espace (13) communiquant avec ladite zone interne (7) par au moins deux ouvertures , une première desdites sous-parois (9) étant en regard de l'extérieur dudit conteneur, une seconde desdites sous-parois (10) étant en regard de ladite zone interne (7) et une troisième desdites sous-parois (11) étant intercalée entre lesdites première (9) et seconde (10) sous-parois, **caractérisé en ce que** ladite première (9) sous-paroi est constituée d'un matériau isolant thermiquement.

2. Conteneur selon la revendication 1, dans lequel ladite troisième sous-paroi (11) est constituée d'un matériau destiné à assurer un transfert de calories entre lesdits premier (12) et second (13) espaces.

3. Conteneur selon l'une des revendications 1 et 2, dans lequel ladite seconde sous-paroi (9) est constituée d'un matériau isolant thermiquement.

4. Conteneur selon l'une des revendications 1 à 3, comprenant au moins un premier dispositif de circulation d'air (20) agencé pour aspirer de l'air à l'extérieur dudit conteneur, par au moins une première desdites ouvertures externes (14,15), faire circuler ledit air extérieur dans ledit premier espace (12), puis expulser ledit air extérieur par au moins une seconde desdites ouvertures externes (16).

5. Conteneur selon la revendication 4, dans lequel une partie au moins dudit dispositif de circulation d'air (20) est installée sensiblement au niveau de ladite seconde ouverture externe (16).

6. Conteneur selon l'une des revendications 4 et 5, dans lequel ledit premier dispositif de circulation d'air (20) comporte au moins un ventilateur.

7. Conteneur selon l'une des revendications 1 à 6, comprenant au moins un second dispositif de circulation d'air (21) agencé pour aspirer de l'air dans ladite zone interne (7), par au moins une première desdites ouvertures internes (17), faire circuler ledit air intérieur dans ledit second espace (13), puis expulser ledit air intérieur par au moins une seconde desdites ouvertures internes (18,19).

8. Conteneur selon la revendication 7, dans lequel une partie au moins dudit second dispositif de circulation d'air (21) est installée sensiblement au niveau de ladite seconde ouverture interne (17).

9. Conteneur selon l'une des revendications 7 et 8, dans lequel ledit second dispositif de circulation d'air (21) comporte au moins un ventilateur.

10. Conteneur selon l'une des revendications 4 à 9, comprenant un dispositif de commande (22) agencé pour contrôler le fonctionnement dudit premier dispositif de circulation d'air (20) et/ou dudit second dispositif de circulation d'air (21).

11. Conteneur selon la revendication 10, dans lequel ledit dispositif de commande (22) est agencé pour contrôler le fonctionnement dudit premier dispositif de circulation d'air (20) et/ou dudit second dispositif de circulation d'air (21) de manière à réguler la température dans ladite zone interne (7).

12. Conteneur selon l'une des revendications 1 à 11, dans lequel la direction de circulation de l'air dans ledit premier espace (12) est sensiblement opposée à la direction de circulation de l'air dans ledit second espace (13).

13. Conteneur selon l'une des revendications 1 à 12, dans lequel au moins trois de ses parois (2, 3, 6) sont constituées desdites sous-parois (9-11).

14. Conteneur selon la revendication 13, dans lequel lesdites trois parois (2, 3, 6) communiquent entre-elles de manière à constituer un unique élément conformé.

15. Conteneur selon l'une des revendications 13 et 14, dans lequel l'une desdites trois parois (2, 3, 6) est une paroi supérieure (6).

16. Utilisation du conteneur selon l'une des revendications précédentes pour loger des équipements de téléphonie (8).

## Claims

1. A container (1) comprising walls (2-6) defining an inside zone (7) suitable for housing at feast one piece of equipment (8), at least one of said walls (2-6) being constituted by at least three sub-walls (9-11) spaced apart from one another in such a manner as to define at least first and second air circulation spaces (12, 13), said first space (12) communicating with the outside of said container via at least two outside openings (14-16), and said second space (13) communicating said inside zone (7) via at least two openings, a first one of said sub-walls (9) facing the outside of said container, a second one of said sub-walls (10) facing said inside zone, and a third one of said sub-walls (11) being interposed between said first and second sub-walls (9, 10), the container being **characterized in that** said first sub-wall (9) is constituted by a thermally insulating material.

2. A container according to claim 1, in which said third sub-wall (11) is constituted by a material for enabling heat to be transferred between said first and second spaces (12, 13).

3. A. container according to claim 1 or claim 2, in which said second sub-wall (9) is constituted by a thermally insulating material.

4. A container according to any one of claims 1 to 3, including at least a first air circulator device (20) arranged to suck in air from outside said container via at least a first one of said outside openings (14, 15), to cause said outside air to circulate in said first space (12), and then to expel said outside air through at least a second one or said outside openings (16),

5. A container according to claim 4, in which at least a portion of said air circulator device (20) is installed substantially in said second outside opening (16).

6. A container according to claim 4 or claim 5, in which said first air circulator device (20) comprises at least one fan.

7. A container according to any one of claims 1 to 6, including at least one second air circulator device (21) arranged to suck air in from said inside zone (7) via at least one of said first inside openings (17), to cause said inside air to circulate in said second space (13), and then to expel said inside air through at least a second one of said inside openings (18, 19),

8. A container according to claim 7, in which a portion at least of said second air circulator device (21) is installed substantially in said second inside opening (17).

9. A container according to claim 7 or claim 8, in which said second air circulator device (21) comprises at least one fan.

10. A container according to any one of claims 4 to 9, including a control device (22) arranged to control the operation of said first air circulator device (20) and/or of said second air circulator device (21).

11. A container according to claim 10, in which said control device (22) is arranged to control the operation of said first air circulator device (20) and/or of said second air circulator device (21) in such a manner as to regulate the temperature in said inside zone (7).

12. A container according to any one of claims 1 to 11, in which the direction of air circulation in said first space (12) is substantially opposite to the direction of air circulation in said second space (13).

13. A container according to any one of claims 1 to 12, in which at least three of its walls (2, 3, 6) are constituted by said sub-walls (9-11).

14. A container according to claim 13, in which said three walls (2, 3, 6) communicate with one another in such a manner as to constitute a single-shaped element.

15. A container according to claim 13 or claim 14, in which one of said three walls (2, 3, 6) is a top wall (6).

16. The use of the container according to any preceding claim for housing telephone equipment (8).

## Patentansprüche

1. Container (1), der Wände (2-6)einschließt, welche einen Innenbereich (7) begrenzen, der mindestens eine Anlage (8) aufnehmen kann, wobei mindestens eine dieser Wände (2-6) aus mindestens drei Unterwänden (9-11) besteht, die so mit Zwischenraum angeordnet sind, dass mindestens ein erster (12) und ein zweiter (13) Luftzirkulationsraum definiert wird, wobei dieser erste Raum (12) mit der Außenseite dieses Containers über mindestens zwei Außenöffnungen (14-16) in Verbindung steht, und dieser zweite Raum (13) mit diesem Innenbereich (7) durch mindestens zwei Öffnungen in Verbindung steht, wobei eine erste dieser Unterwände (9) sich gegenüber der Außenseite dieses Containers befindet, eine zweite dieser Unterwände (10) sich gegenüber dieses Innenbereichs (7) befindet und eine dritte dieser Unterwände (11) zwischen diese erste (9) und diese zweite (10) Unterwand zwischengeschaltet ist, **dadurch gekennzeichnet, dass** diese erste Unterwand (9) aus einem thermisch isolierenden Material besteht.

2. Container gemäß Anspruch 1, bei dem diese dritte Unterwand (11) aus einem Material besteht, das eine Kalorienübertragung zwischen diesem ersten (12) und diesem zweiten (13) Raum gewährleisten soll.

3. Container gemäß einem der Ansprüche 1 und 2, bei dem diese zweite Unterwand (9) aus einem thermisch isolierenden Material besteht.

4. Container gemäß einem der Ansprüche 1 bis 3, der mindestens eine erste Luftzirkulationsvorrichtung (20) einschließt, die so aufgebaut ist, dass sie Luft außerhalb dieses Containers durch mindestens eine erste dieser Außenöffungen (14, 15) ansaugt, dann diese Außenluft in diesem ersten Raum (12) zirkulieren lässt, dann diese Außenluft durch mindestens eine zweite dieser Außenöffnungen (16) nach außen ausstoßt.

5. Container gemäß Anspruch 4, bei dem zumindest ein Teil dieser ersten Luftzirkulationsvorrichtung (20) etwa auf der Ebene dieser zweiten Außenöffnung (16) installiert wird.

6. Container gemäß einem der Ansprüche 4 und 5, bei dem diese erste Luftzirkulationsvorrichtung (20) mindestens einen Lüfter einschließt.

7. Container gemäß einem der Anspräche 1 bis 6, der mindestens eine zweite Luftzirkulationsvorrichtung (21) einschließt, die so aufgebaut ist, dass sie Luft in diesem Innenbereich (7) durch mindestens eine erste dieser Innenöffnungen (17) ansaugt, diese Innenluft in diesem zweiten Raum (13) zirkulieren lässt, dann diese Innenluft durch mindestens eines zweite dieser Innenöffnungen (18, 19) in den Innenraum ausstößt.

8. Container gemäß Anspruch 7, bei dem zumindest ein Teil dieser zweiten Luftzirkulationsvorrichtung (21) etwa auf der Ebene dieser zweiten Innenöffnung (17) installiert wird.

9. Container gemäß einem der Ansprüche 7 und 8, bei dem diese zweite Luftzirkulationsvorrichtung (21) mindestens einen Lüfter einschließt.

10. Container gemäß einem der Ansprüche 4 bis 9, der eine Steuerungsvorrichtung (22) einschließt, die so aufgebaut ist, dass sie die Funktion dieser ersten Luftzirkulationsvorrichtung (20) und/oder dieser zweiten Luftzirkulationsvorrichtung (21) steuert.

11. Container gemäß Anspruch 10, bei dem diese Steuerungsvorrichtung (22) so aufgebaut ist, dass sie die Funktion dieser ersten Luftzirkulationsvorrichtung (20) und/oder dieser zweiten Luftzirkulationsvorrichtung (21) steuert, um die Temperatur in diesem Innenbereich (7) zu regeln.

12. Container gemäß einem der Ansprüche 1 bis 11, bei dem die Zirkulationsrichtung der Luft in diesem ersten Raum (12) der Zirkulationsrichtung der Luft in diesem zweiten Raum (13) etwa entgegen gesetzt ist.

13. Container gemäß einem der Ansprüche 1 bis 12, bei dem mindestens drei seiner Wände (2, 3, 6) aus diesen Unterwänden (9-11) bestehen.

14. Container gemäß Anspruch 13, bei dem diese drei Wände (2, 3, 6) untereinander in Verbindung stehen, um ein einziges gestaltetes Element zu bilden.

15. Container gemäß einem der Ansprüche 13 und 14, bei dem eine dieser drei Wände (2, 3, 6) eine obere Wand (6) ist.

16. Nutzung des Containers gemäß einem der vorstehenden Ansprüche zur Unterbringung von Fernsprechanlagen (8).
